# EUROPÄISCHE PATENTSCHRIFT

(11) **EP 0 687 700 B1**
(45) Veröffentlichungstag und Bekanntmachung des Hinweises auf die Patenterteilung: **10.06.1998**
(21) Anmeldenummer: 95113081.4
(22) Anmeldetag: 03.12.1991
(51) Int. Cl.: C08G 73/04, B41N 3/03, C08F 8/34, C08F 8/40, C08L 39/02

(54) **Neue Polyvinylamin-Derivate, mit diesen Derivaten beschichtete Trägermaterialien auf der Basis von Aluminium sowie deren Verwendung zur Herstellung von Offsetdruckplatten**
Polyvinylamine derivatives, aluminium-based carriers coated with them and their use in making off-set printing plates
Dérivés de polyvinylamine, supports à base d'aluminium recouverts de ceux-ci et leur utilisation dans la fabrication de plaques offset

(30) Priorität: 14.12.1990 DE 4039920
(43) Veröffentlichungstag der Anmeldung: 20.12.1995
(62) Teilanmeldung aus: 91120737.1
(73) Patentinhaber: Agfa-Gevaert AG, 51373 Leverkusen (DE)
(72) Erfinder: Roser, Joachim, Dr., D-68165 Mannheim (DE); Mohr, Jürgen, Dr., D-67269 Grünstadt (DE); Lange, Armin, Dr., D-69121 Heidelberg (DE); Oppenländer, Knut, Dr., D-67061 Ludwigshafen (DE); Denzinger, Walter, D-67346 Speyer (DE); Loerzer, Thomas, Dr., D-76829 Landau (DE)

(56) Entgegenhaltungen:
- EP-A- 0 216 387
- WO-A-91/02011
- DE-A- 1 620 977
- FR-A- 2 173 074
- FR-A- 2 407 989
- GB-A- 976 566
- US-A- 2 600 806

## Beschreibung

Die Erfindung betrifft neue Polyvinylamin-Derivate, mit diesen Derivaten beschichtete platten-, folien- oder bandförmige Trägermaterialien (im folgenden auch Schichtträger genannt) auf der Basis von Aluminium und deren Verwendung zur Herstellung von lichtempfindlichen Aufzeichnungselementen und Offsetdruckplatten.

Trägermaterialien für Offsetdruckplatten werden ein- oder beidseitig mit einer lichtempfindlichen Schicht (Kopierschicht) versehen, mit deren Hilfe auf photomechanischem Wege ein druckendes Bild erzeugt wird. Nach Herstellung des druckenden Bildes trägt der Schichtträger die druckenden Bildstellen und bildet zugleich an den bildfreien Stellen (Nichtbildstellen) den hydrophilen Bilduntergrund für den lithographischen Druckvorgang.

Ein Schichtträger für lichtempfindliches Material zur Herstellung von lithographischen Platten muß folgende Anforderungen erfüllen:
a) Die nach der Belichtung relativ gut löslichen Teile der lichtempfindlichen Schicht müssen im Entwicklungsschritt leicht und rückstandsfrei zur Erzeugung der hydrophilen Nichtbildstellen vom Träger zu entfernen sein.
b) Der in den Nichtbildstellen freigelegte Schichtträger muß eine große Affinität zu Wasser besitzen, d.h. stark hydrophil sein, um beim lithographischen Druckvorgang schnell und dauerhaft Wasser aufzunehmen und gegenüber der fetten Druckfarbe ausreichend abstoßend zu wirken.
c) Die Haftung der lichtempfindlichen Schicht vor der Belichtung wie auch der druckenden Teile der Schicht an den Bildstellen nach der Belichtung muß in einem ausreichenden Maß gegeben sein.

Als Basismaterial für derartige Schichtträger können Aluminium-, Stahl-, Kupfer-, Messing- oder Zink-, aber auch Kunststoff-Folien oder Papier verwendet werden. Diese Rohmaterialien werden durch geeignete Operationen wie z.B. Körnung, Mattverchromung, oberflächliche Oxidation und/oder Aufbringen einer Zwischenschicht in Schichtträger für Offsetdruckplatten überführt. Aluminium, das wohl am häufigsten verwendete Basismaterial für Offsetdruckplatten, wird hierbei bekanntermaßen nach Methoden wie Trockenbürstung, Naßbürstung, Sandstrahlen, chemische und/oder elektrochemische Behandlung oberflächlich aufgerauht. Zur Steigerung der Abriebfestigkeit kann das aufgerauhte Substrat noch einem Anodisierungsschritt zum Aufbau einer dünnen Oxidschicht unterzogen werden.

Nach dem Stand der Technik ist es üblich, solche anodisierten Trägermaterialien zur Erleichterung der Entwickelbarkeit der bildmäßig belichteten lichtempfindlichen Schicht, zur Steigerung der Hydrophilie bzw. zur Verbesserung der Haftung der lichtempfindlichen Schicht einem weiteren Behandlungsschritt zu unterziehen. In der Patentliteratur sind hierzu unter anderem Methoden wie Silikatisierung (vgl. z.B. DE-A 2 532 769 bzw. US-A 3 902 976), die Behandlung mit komplexen Fluoriden (vgl. z.B. DE-B 13 00 415 bzw. US-A 3 440 050) oder mit Polyvinylphosphonsäure (vgl. z.B. DE-C 11 34 093 bzw. US-A 3 276 868, DE-C 16 21 478 bzw. US-A 4 153 461) beschrieben.

Aus der EP-B 190 643 ist ein Trägermaterial für Offsetdruckplatten aus gegebenenfalls vorbehandeltem Aluminium oder seinen Legierungen bekannt, das auf wenigstens einer Seite eine hydrophile Beschichtung aus einer Phosphonsäure-Verbindung trägt, die aus a) einem Polymerisat aus Acrylamidoisobutylenphosphonsäure oder b) einem Copolymerisat aus Acrylamid und Acrylamidoisobutylenphosphonsäure oder c) einem Salz von a) oder b) mit einem mindestens zweiwertigen Metallkation besteht. Diese bekannten Methoden und Beschichtungen haben jedoch Nachteile. So verschlechtert sich durch die Behandlung mit Alkalisilikaten die Lagerfähigkeit.

Aus der DE-B 22 11 553 ist ein Verfahren zum Verdichten von anodischen Oxidschichten auf Aluminium und Aluminiumlegierungen in wäßrigen, Phosphonsäuren oder deren Salze und Kalziumionen enthaltenden Lösungen mit einem pH-Wert von 5-6,5 bei Temperaturen zwischen 90°C und der Siedetemperatur bekannt, bei dem mit Lösungen gearbeitet wird, die eine oder mehrere Phosphonsäuren enthalten und das molare Verhältnis von Kalziumionen zu Phosphonsäure auf mindestens 2:1 eingestellt wird.

Mit Polyvinylphosphonsäure behandelte Trägermaterialien neigen dagegen bei Lagerung im unbeschichteten Zustand zu Alterungserscheinungen. Diese manifestieren sich in abnehmender Hydrophilie sowie in der verringerten Aufentwickelbarkeit von negativ arbeitenden Schichten, die erst längere Zeit nach Trägerherstellung beschichtet werden.

Aufgabe der Erfindung war es deshalb, chemische Verbindungen aufzuzeigen, die als Zwischenschicht zwischen dem Trägermaterial und einer positiv, negativ oder elektrophotographisch arbeitenden lichtempfindlichen Schicht die Hydrophilie der Nichtbildstellen erhöhen, ohne die Haftung der lichtempfindlichen Schicht auf dem Trägermaterial negativ zu beeinflussen, und damit die erwähnten Nachteile bekannter Behandlungsmittel vermeiden. Diese Aufgabe wird überraschend durch die Polyvinylamine mit den Strukturelementen IIₐ, II_{b} und II_{c} 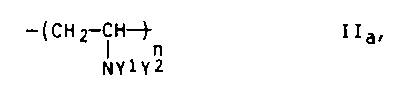 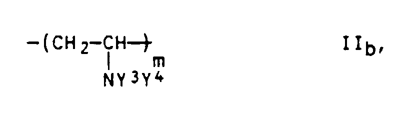 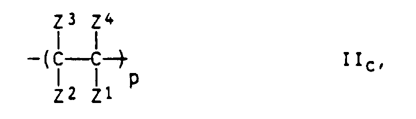 oder den Mischungen mit Polyethyleniminen mit den Strukturelementen Iₐ und/oder I_{b} 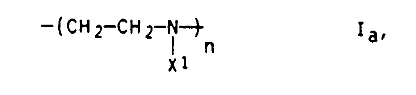 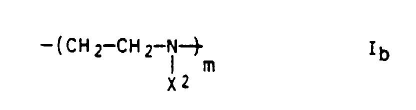 gelöst, wobei für die Polymerisationsgrade n, m und p gilt, daß
n ≥ 1,
m ≥ 0,
p ≥ 0 ist,
und
- X¹: CR¹R²PO₃R³R⁴ oder CR¹R²SO₃R³,
- X²: unabhängig von X¹ ein Wasserstoffatom, CR¹R²PO₃R³R⁴ oder CR¹R²SO₃R³,
- Y¹, Y²: unabhängig voneinander mindestens eine CHR¹PO₃R³R⁴- oder CHR¹SO₃R³-Gruppierung und eventuell ein Wasserstoffatom,
- Y³, Y⁴: unabhängig voneinander und von Y¹ und Y² Wasserstoffatome, CHR¹PO₃R³R⁴- oder CHR¹SO₃R³-Gruppierungen und
- Z¹-Z⁴: gleich oder verschiedene anorganische und/oder organische Reste bedeuten,
worin
- R¹, R²: unabhängig voneinander ein Wasserstoffatom, eine C₁-C₁₂-Alkylgruppe oder eine Arylgruppe,
- R³, R⁴: unabhängig voneinander ein Wasserstoff- oder Alkalimetallatom, oder aber NR⁵R⁶R⁷R⁸ bedeuten, wobei R⁵ bis R⁸ gleiche oder ungleiche Reste sind, die aus der Gruppe Wasserstoff, Alkyl, Aryl, Hydroxyalkyl oder Benzyl gewählt sind.

Erfindungsgemäß bevorzugt sind hiervon Polyethylenimine und Polyvinylamine, bei denen R₁ und R₂ Wasserstoffatome sowie R₃ und R₄ Wasserstoffatome oder Alkalimetallatome sind.

Das Molekulargewicht der erfindungsgemäßen Polyvinylamine liegt zwischen 1000 und 2 500 000, bevorzugt zwischen 3000 und 2 000 000 und besonders bevorzugt zwischen 5000 und 500 000.

Das Molekulargewicht der erfindungsgemäß gegebenenfalls mitzuverwendenden Polyethylenimine liegt zwischen 150 und 2 500 000, bevorzugt zwischen 1000 und 1 900 000 und besonders bevorzugt zwischen 5000 und 100 000.

Alle Molekulargewichte beziehen sich auf das Gewichtsmittel.

Die erfindungsgemäßen Polyvinylamine können bis zu 95 Gew.-%, vorzugsweise 10 bis 90 Gew.-% und besonders bevorzugt 20 bis 80 Gew.-% an Comonomeren enthalten (Strukturelement IIc).

Geeignete Comonomere sind monoethylenisch ungesättigte C₃-C₆-Carbonsäuren, deren Ester, Amide und Nitrile. Beispiele für derartige Verbindungen sind Acrylsäure, Methacrylsäure, Crotonsäure, Maleinsäure(anhydrid), Fumarsäure, Itaconsäure(anhydrid), Acrylsäuremethylester, Acrylsäureethylester, Methacrylsäuremethylester, Methacrylsäurebutylester, Dimethylaminoethylacrylat, Dimethylaminoethylmethacrylat, Maleinsäuremonoethylester, Maleinsäurediethylester, Hydroxyethylacrylat, Hydroxypropylacrylat, Hydroxyethylmethacrylat, Hydroxypropylmethacrylat, Methacrylamidopropyldimethylammoniumchlorid, Dimethylaminopropylacrylamid, Acrylnitril und Methacrylnitril. Weiterhin sind geeignet Sulfonsäuregruppen enthaltende Monomere wie z.B. Vinylsulfonsäure, Allylsulfonsäure, Methallylsulfonsäure, Styrolsulfonsäure, Acryl-(3-sulfopropyl)ester, Methacrylsäure-(3-sulfopropyl)ester und Acrylaminomethylpropansulfonsäure.

Außerdem eignen sich auch N-Vinylpyrrolidon, N-Vinylcaprolactam, N-Vinylimidazol, N-Vinylmethylimidazol, N-Vinyl-2-methylimidazol, Vinylacetat, Vinylpropionat, Vinylbutyrat, Styrol, Olefine mit 2 bis 10 C-Atomen wie Ethylen, Propylen, Isobutylen, Hexen, Diisobuten und Vinylalkylether, wie Methylvinylether, Ethylvinylether, n-Butylvinylether, Isobutylvinylether, Hexylvinylether und Octylvinylether, sowie Mischungen der genannten Monomere.

Saure Monomere, d.h. ethylenisch ungesättigte Monomere, die Carbonsäure- oder Sulfonsäuregruppen enthalten, können bei der Polymerisation, insbesondere in wäßriger Lösung, in teilweise oder vollständig neutralisierter Form eingesetzt werden. Zur Neutralisation verwendet man vorzugsweise Alkalimetallbasen, wie Natronlauge und Kalilauge bzw. Ammoniak oder Amine, z.B. Trimethylamin, Ethanolamin oder Triethanolamin.

Die basischen Monomere werden vorzugsweise in Form der Salze mit Mineralsäuren, z.B. Salzsäure oder Schwefelsäure, oder in quaternierter Form eingesetzt (geeignete Quaternierungsmittel sind beispielsweise Dimethylsulfat, Diethylsulfat, Methylchlorid, Ethylchlorid oder Benzylchlorid).

Die erfindungsgemäßen Polyvinylamine und die Polyethylenimine können Phosphonomethylgruppen CR¹R²PO₃R³R⁴ oder Sulfonomethylgruppen CR¹R²SO₃R³ oder beide Gruppen zugleich enthalten. Bevorzugt sind Polyvinylamine, die entweder Phosphonomethyl- oder Sulfonomethylgruppen aufweisen. Die erfindungsgemäßen Polyvinylamine können in geringen Mengen Imin- bzw. Aminostickstoffatome enthalten, bei denen das eine Wasserstoffatom bzw. die beiden Wasserstoffatome nicht substituiert sind. In den erfindungsgemäßen Polymeren sind aber mindestens 15 % der Imin- bzw. Aminogruppen substituiert.

Gegenstand der Erfindung sind außerdem mit den erfindungsgemäßen Polyvinylaminen oder deren Gemischen mit Polyethyleniminen beschichtete Trägermaterialien auf der Basis von Aluminium.

Diese Trägermaterialien sind erhältlich, indem man die erfindungsgemäßen Verbindungen oder aber deren Mischungen im allgemeinen in Form ihrer wäßrigen Lösungen (Konzentrationsbereich: 0,01 bis 5 Gew.-%) durch übliche Applikationsverfahren wie Sprühen oder Tauchen auf den vorbehandelten Aluminiumträger aufträgt. Die erfindungsgemäßen Polyvinylamine oder deren Gemische mit Polyethyleniminen können dabei mit oder ohne Säuren-, Laugen- oder pH-Pffersätze eingesetzt werden. Ein Überschuß wird gegebenenfalls entfernt und der beschichtete Träger bei 20 bis 130°C getrocknet.

Lichtempfindliche Aufzeichnungselemente aus einem auf übliche Weise mechanisch, chemisch und/oder elektrochemisch vorbehandelten und gegebenenfalls anodisch oxidierten Träger auf der Basis von Aluminium und einer positiv, negativ oder elektrophotographisch arbeitenden lichtempfindlichen Schicht können dadurch hergestellt werden, daß man zwischen Aluminiumträger und lichtempfindlicher Schicht eine dünne hydrophilierende Schicht, die die erfindungsgemäßen Verbindungen enthält, und vorzugsweise aus diesen besteht, aufbringt.

Gegenstand der Erfindung ist demgemäß auch die Verwendung der mit den erfindungsgemäßen Polyvinylaminen oder deren Gemischen mit Polyethyleniminen beschichteten Aluminiumträger zur Herstellung von Offsetdruckplatten und lichtempfindlichen Aufzeichnungselementen.

Die Herstellung der erfindungsgemäßen Polyvinylamine erfolgt beispielsweise durch Phosphonomethylierung und/oder Sulfonomethylierung von entsprechenden unsubstituierten Polyvinylaminen auf bekannte Weise (vgl. K. Moedritzer, R.R. Irani, Journal of Organic Chemistry, Vol. 31, 1603 (1966); D. Redmore, Topics in Phosporus Chemistry, Vol. 8, 515 (1976)).

Die unsubstituierten Polyvinylamine können beispielsweise durch Polymerisation von N-Vinylformamid und anschließende Entfernung der Schutzgruppen durch Hydrolyse hergestellt werden. Die unsubstituierten Polyethylenimine können durch kationische oder anionische Polymerisation von Ethylenimin hergestellt werden.

Zur Phosphonomethylierung werden die unsubstituierten Polymeren beispielsweise mit Formaldehyd und phosphoriger Säure in stark saurem, meist salzsaurem, Medium bei Reaktionszeiten zwischen 5 und 30 Stunden, bevorzugt zwischen 15 und 25 Stunden umgesetzt.

Danach erhält man in der Regel die vollständig phosphonomethylierten Polymeren. Bei der Anwendung unterstöchiometrischer Mengen an Formaldehyd und phosphoriger Säure isoliert man Produkte bzw. Produktgemische, die nur partiell phosphonomethyliert sind.

Falls daher die vollständige Umsetzung gewünscht ist, empfiehlt es sich, die übrigen Reagenzien gegenüber den Amin- bzw. Imingruppen der Polymeren in einem solchen Überschuß im Vergleich zur Stöchiometrie einzusetzen, daß eine erschöpfende Phosphonomethylierung gewährleistet ist.

Zur Aufarbeitung nach erfolgter Phosphonomethylierung können zunächst durch Behandlung des salzsauren Reaktionsgemisches mit Wasserdampf überschüssige Säure und sonstige Ausgangsprodukte sowie flüchtige Nebenprodukte weitestgehend ausgetrieben werden.

Die Umsetzungsprodukte sind gegebenenfalls bereits in Form dieser wäßrigen Lösungen oder aber nach Eindampfen oder Konzentrieren verwendbar.

Es kann jedoch von Vorteil sein, die Produkte vor dem weiteren Einsatz einer zusätzlichen Reinigung zu unterziehen.

Dazu können die nach der Wasserdampfbehandlung erhaltenen, teilweise sehr viskosen Lösungen oder Mischungen der polymeren Säure mit wäßrigen Lösungen von Alkalimetallhydroxiden umgesetzt werden. Die Polymere können dann in Form ihrer Alkalimetallsalze durch Fällung aus geeigneten Lösungsmitteln, z.B. aus Methanol, in guter Reinheit erhalten werden.

Es ist ebenfalls möglich, die konzentrierten, noch sauren Lösungen, zu einer methanolischen Alkalilauge zu geben, so daß gleichzeitig Neutralisation zu den Alkalimetallsalzen und deren Fällung erfolgt.

Die Sulfonomethylierung bzw. die gleichzeitige Sulfonomethylierung und Phosphonomethylierung können auf analoge Weise erfolgen, wobei schweflige Säure statt bzw. zusätzlich zur phosphorigen Säure verwendet wird.

In den erfindungsgemäßen Polymeren sind 15 bis 95 %, bevorzugt 25 bis 80 und besonders bevorzugt 35 bis 70 % der Amin- bzw. Imingruppen durch derartige Gruppen substituiert.

Die für die erfindungsgemäße Verwendung einzusetzenden Aluminiumträger sind auf übliche Weise mechanisch, chemisch und/oder elektrochemisch vorbehandelt und gegebenenfalls anodisch oxidiert. Derartige Vorbehandlungsmethoden sind beispielsweise beschrieben in Wernick, Pinner, Zurbrügg, Weiner, "Die Oberflächenbehandlung von Aluminium", Eugen G. Leuze Verlag, 1977.

Nach der Behandlung des vorbehandelten Aluminiumträgers mit der Lösung der erfindungsgemäßen Polyvinylamine oder deren Gemischen mit Polyethyleniminen und Trocknen der dünnen Schicht wird der nachbehandelte Aluminiumträger auf übliche Weise mit der lichtempfindlichen Schicht versehen. Diese Lichtempfindliche Schicht kann aus einem Einschicht- oder aus einem Zweischichtsystem aufgebaut sein.

Als lichtempfindliche Schichten sind grundsätzlich alle Schichten geeignet, die nach dem Belichten, gegebenenfalls mit einer nachfolgenden Entwicklung und/oder Fixierung eine bildmäßige Fläche liefern, von der gedruckt werden kann. Sie werden entweder beim Hersteller von vorsensibilisierten Druckplatten oder direkt vom Verbraucher auf eines der üblichen Trägermaterialien aufgebracht.

Neben den auf vielen Gebieten verwendeten, Silberhalogenide enthaltenden, Schichten sind auch verschiedene andere bekannt, wie sie z.B. in "Light-Sensitive Systems" von J. Kosar, John Wiley & Sons Verlag, New York 1965, beschrieben werden: Chromate und Dichromate enthaltende Kolloidschichten; ungesättigte Verbindungen enthaltende Schichten, in denen diese Verbindungen beim Belichten isomerisiert, umgelagert, cyclisiert oder vernetzt werden; photopolymerisierbare Verbindungen enthaltende Schichten, in denen Monomere oder Präpolymere gegebenenfalls mittels eines Initiators beim Belichten polymerisieren; und o-Diazochinone wie Naphthochinondiazide, p-Diazochinone oder Diazoniumsalz-Kondensate enthaltende Schichten.

Zu den geeigneten Schichten zählen auch die elektrophotographischen Schichten, d.h. solche, die einen anorganischen oder organischen Photoleiter enthalten. Außer den lichtempfindlichen Substanzen können diese Schichten noch andere Bestandteile wie z.B. Harze, Farbstoffe oder Weichmacher enthalten.

Offsetdruckplatten, deren Basisträgermaterialien erfindunggemäß behandelt wurden, weisen gegenüber bekannten Offsetdruckplatten einen deutlich geringer ausgeprägten Farbschleier und eine verbesserte Hydrophilie auf. Auch die Haftung der lichtempfindlichen Schicht auf der Trägeroberfläche ist deutlich besser.

### Beispiele

Im Synthesebeispiel ist beispielhaft die Synthese eines erfindungsgemäß gegebenenfalls mitzuverwendenden Polyethylenimins angegeben.

In den Beispielen bzw. Vergleichsbeispielen wurden vier unterschiedlich vorbehandelte Aluminumbleche T1 bis T4 Nachbehandlungen mit den erfindungsgemäßen Hydrophilisierungschemikalien B1 bis B13 bzw. den bekannten Hydrophilisierungschemikalien V1 bis V5 unterzogen.

An den nachbehandelten Trägerblechen bzw. den hieraus durch Beschichtung mit einer lichtempfindlichen Schicht erhaltenen Blechen wurden Tests auf Farbschleier (F), Hydrophilie (H), Korrigierbarkeit (K) und Druckverhalten (D) durchgeführt.

### Synthesebeispiel

### Herstellung eines phosphonomethylierten Polyethylenimin-Derivates

110 g des Polyethylenimins, gelöst in 500 ml Wasser, wurden mit 200 ml konz. Salzsäure und 200 g phosphoriger Säure versetzt und die Mischung bis zum Rückfluß erhitzt. Dann wurden 250 g einer wäßrigen, 30 %-igen Formaldehydlösung langsam zugetropft. Nach beendeter Zugabe wurde noch 20 Stunden lang unter Rückfluß gerührt. Flüchtige Anteile und überschüssige Reagenzien wurden durch dreistündige Wasserdampfbehandlung entfernt und die erhaltene Lösung auf ca. ein Drittel ihres Volumens eingeengt.

Zur Reinigung des phosphonomethylierten Polymeren wurde dieses als Natriumsalz gefällt, indem man die noch saure konzentrierte Lösung in das zehnfache Volumen methanolischer Natronlauge eintropfte, wobei die eingesetzte NaOH-Menge dem Säurezahl-Äquivalent der eingeengten Reaktionsmischung entsprechen sollte. Das ausgefällte Natriumsalz wurde abfiltriert, mit Methanol nachgewaschen und getrocknet. Danach wurden ca. 450 g des Na-Salzes des phosphonomethylierten Polyethylenimins als hellgelbes Pulver erhalten.

Das elementaranalytische Massenverhältnis von organisch gebundenem Phosphor zu organisch gebundenem Stickstoff betrug 1,7; entsprechend einem Phosphonomethylierungsgrad von 77 %.

### Aluminiumträger

Es wurden die folgenden Aluminiumbleche T1 bis T4 eingesetzt.
- T1:: Ein elektrochemisch durch Wechselstrombehandlung in wäßriger Salzsäure aufgerauhtes und anodisch in wäßriger Schwefelsäure oxidiertes Aluminiumblech mit einem mittleren Oxidschichtgewicht von 3 g/m² und einem mittleren Ra-Wert von 0,6-0,7.
- T2:: Wie T1 aber mit einem mittleren Ra-Wert von 0,3-0,4.
- T3:: Ein elektrochemisch durch Wechselstrombehandlung in wäßriger Salpetersäure aufgerauhtes und anodisch in Schwefelsäure oxidiertes Aluminiumblech mit einem mittleren Oxidschichtgewicht von 3 g/m² und einem mittleren Ra-Wert von 0,6-0,7.
- T⁴:: Wie T3 aber mit einem mittleren Ra-Wert von 0,3-0,4.

### Nachbehandlung

In allen Beispielen (B9-B13) und Vergleichsbeispielen (V1-V5) wurden die wie oben vorbehandelten Träger unter den in Tabelle 2 angegebenen Bedingungen (Temperatur, Konzentration, pH-Wert) für 60 Sekunden in eine Lösung der entsprechenden Hydrophilierungschemikalien eingetaucht, anschließend gründlich mit Wasser gespült und bei 80°C getrocknet.

Für die erfindungsgemäße Nachbehandlung wurden die folgenden erfindungsgemäßen Polymeren (B9-B13: Polyvinylamine) als Hydrophilisierungschemikalien eingesetzt (vgl. Tabelle 1):

**Tabelle 1**

| Nr. | Struktur-Elemente | Molekulargewicht | X¹ bzw. Y¹, Y² |
|---|---|---|---|
| B9 | IIa | 6 000 | H, CH₂PO₃H |
| | | | |
| B10 | IIa | 40 000 | H, CH₂PO₃H |
| | | | |
| B11 | IIa | 1 600 000 | H, CH₂PO₃H |
| | | | |
| B12 | IIa | 2 000 000 | H, CH₂PO₃H |
| | | | |
| B13 | IIa | 40 000 | H, CH₂SO₃H |

Für die bekannte Nachbehandlung wurden die folgenden Vergleichssubstanzen als Hydrophilisierungschemikalien eingesetzt:
- V1:: Wasser
- V2:: Ammoniumacetat
- V3:: Natriumsilikat
- V4:: Polyvinylphosphonsäure
- V5:: Trihydroxisilylethylphosphonsäure

### Lichtempfindliche Schichten

Die mit den oben beschriebenen erfindungsgemäßen und bekannten Hydrophilierungschemikalien nachbehandelten Trägerbleche wurden mit folgenden lichtempfindlichen Schichten versehen:
L1: positive Kopierschicht, bestehend aus

| | |
|---|---|
| 70 Gew.-% | eines Kresol-Formaldehyd-Novolaks (mit einem Erweichungsbereich von 105-120°C nach DIN 53181), |
| 27 Gew.-% | eines Reaktionsproduktes von 1,2-Naphthochinon-2-diazid-5-sulfonsäure mit dem Kondensationsprodukt von Aceton und Pyrogallol, |
| 2 Gew.-% | 4-(p-Tolylmercapto)-2,5-diethoxy-benzoldiazonium-hexafluoroarsenat und |
| 1 Gew.-% | Kristallviolett. |

L2: positive, umkehrbare Kopierschicht, bestehend aus

| | |
|---|---|
| 70 Gew.-% | eines Kresol-Formaldehyd-Novolaks (mit einem Erweichungsbereich von 105-120°C nach DIN 53181), |
| 27 Gew.-% | eines Reaktionsproduktes von 1,2-Naphthochinon-2-diazid-4-sulfonsäure mit dem Kondensationsprodukt aus Formaldehyd und p-Kresol, |
| 2 Gew.-% | 4-(p-Tolylmercapto)-2,5-diethoxy-benzoldiazonium-hexafluoroarsenat und |
| 1 Gew.-% | Kristallviolett. |

L3: negative Kopierschicht, bestehend aus

| | |
|---|---|
| 87,5 Gew.-% | eines Bindemittels, das 12 Gew.-% Methacrylanilid, 59 Gew.-% Ethylacrylat, 20 Gew.-% Acrylnitril und 9 Gew.-% Methacrylsäure enthält, |
| 10 Gew.-% | eines Kondensationsproduktes von p-Diazodiphenylaminsulfat mit Formaldehyd, isoliert als Hexafluorophosphat (die Kondensation wurde in Schwefelsäure durchgeführt) und |
| 2,5 Gew.-% | einer Mischung aus Triarylmethanfarbstoffen, bestehend aus 70 Gew.-% Flexoblau® 680 und 30 Gew.-% Hektoviolett® 610. |

L4: elektrophotographische Kopierschicht, bestehend aus

| | |
|---|---|
| 54,6 Gew.-% | eines Bindemittels, das 70 Gew.-% Styrol, 24 Gew.-% Acrylsäure und 6 Gew.-% Maleinsäureanhydrid enthält, |
| 45 Gew.-% | Bis-(dimethylaminophenyl)-oxdiazol |
| 0,4 Gew.-% | Rhodamin B-Base (C.I. Solvent Red 49). |

Die Beschichtung der Trägerbleche mit den lichtempfindlichen Schichten erfolgte mittels Rakel-, Schleuder- oder Walzenauftrag, wobei die Auftragsart keinen Einfluß auf die untersuchten Eigenschaften hatte.

Die Beschichtungen wurden so vorgenommen, daß nach dem Trocknen bei Temperaturen bis 120°C die Kopierschicht ein Schichtgewicht von 1,8-2,3 g/m2 und Restlösungsmittelgehalte von weniger als 5 Gew.-% aufwies. Vergleichsuntersuchungen mit der lichtempfindlichen Schicht L1 zeigten, daß die Variation des Schichtgewichts im Bereich 1,0-3,5 g/m2 keinen nachteiligen Effekt auf die untersuchten Eigenschaften hat.

Als Lösungsmittel wurden Ethylen- und Propylen-Glykolmonomethylether, sowie deren Gemische mit Aceton verwendet. Vergleichsversuche unter Verwendung der lichtempfindlichen Schicht L1 mit einer Reihe von organischen Lösungsmitteln und Lösungsmittelgemischen zeigten, daß alle organischen Lösungsmittel die mit den Einsatzstoffen nicht reagieren, ebenso verwendbar sind.

### Herstellung der Druckformen:

Aus den wie vorstehend beschrieben hergestellten Druckplatten ließen sich auf dem üblichen Weg die entsprechenden Druckformen herstellen. Bei den Druckplatten mit den lichtempfindlichen Schichten L1-L3 wurden die Druckplatten durch eine Testvorlage (UGRA-Offset-Testkeil 1982) hindurch mit einem handelsüblichen Metallhalogenid-Belichter (5,5 kW; Lampenabstand ca. 70 cm) belichtet und anschließend mit einem handelsüblichen Positiv- bzw. Negativ-Entwickler entwickelt. Das Umkehren der positiven, umkehrbaren Kopierschicht wurde durch Erwärmen der bildmäßig belichteten Platte auf 100 - 150°C für 30-300 Sekunden und anschließende vollflächige Nachbelichtung durchgeführt.

Bei den Druckplatten mit der elektrophotographischen Kopierschicht L4 wurde die Schicht mit einer Corona und einer damit verbundenen Hochspannungsquelle von 7 kV aufgeladen und ein in einer Reprokamera mit Halogenstrahlern durch eine Testvorlage hindurch, die auch den UGRA-Offset-Testkeil 1982 enthielt, belichtet. Nach der Betonerung des durch die Belichtung entstandenen latenten Ladungsbildes mit einem handelsüblichen Toner erhielt man ein Bild der Vorlage, welches durch Wärmeeinwirkung fixiert wurde. Zur Umwandlung in eine Druckform wurde das Aluminiumblech mit der betonerten Schicht mit Hilfe eines handelsüblichen wäßrig-alkalischen Entwicklers entwickelt.

### Testversuche

An den auf bekannte Weise und erfindungsgemäß nachbehandelten Trägerblechen bzw. Druckplatten wurden die vier folgenden Tests durchgeführt. Die gefundenen Testergebnisse sind in Tabelle 2 aufgeführt. Da sich für die unterschiedlich vorbehandelten Bleche T1 bis T4 keine Unterschiede ergaben, sind diese in Tabelle 2 nicht aufgeführt.

### Farbschleier (F):

Zur Beurteilung des Farbschleiers wurden 5 x 10 cm große Druckplatten zur Hälfte nach den oben beschriebenen Methoden entwickelt.

Die freigelegten Nichtbildstellen wurden dann visuell durch Vergleich mit den entsprechenden unbeschichteten Trägerblechen beurteilt, wobei die Bewertungen A, B oder C vergeben wurden.
- A =: kein Farbschleier (Helligkeit der freigelegten Nichtbildstellen entspricht der des unbeschichteten Bleches)
- B =: sehr geringer bis geringer Farbschleier (Helligkeit der freigelegten Nichtbildstellen ist etwas geringer als beim unbeschichteten Blech)
- C =: mittelstarke bis starke Farbschleier (nicht für Offsetdruckplatten geeignet)

### Hydrophilie (H):

Die unbeschichteten, nachbehandelten Trägerbleche wurden mit einer korrigierten Stelle versehen, dann durch überwischen mit offset-typischer Druckfarbe eingefärbt und anschließend mit Wasser abgespült. Mit einer weiteren Probe des Prüfbleches wurde das Vorgehen wiederholt, wobei es vor der Einfärbung für ca. 45 Sekunden in einen handelsüblichen Entwickler getaucht wurde. Es wurden die Bewertungen A, B oder C vergeben.
- A =: sehr hydrophil; kein Tonen (sowohl mit als auch ohne Entwicklerbehandlung vollkommen sauber abgespült; für schwierige Anwendungen beim Offsetdruck geeignet)
- B =: hydrophil; kein Tonen (ohne Entwicklerbehandlung leichtes Tonen, mit Entwicklerbehandlung wie A; für Offsetdruck noch geeignet)
- C =: nicht ausreichend hydrophil bzw. Tonen (auch nach Entwicklerbehandlung nicht freispülbar; für den Offsetdruck nicht geeignet)

### Korrigierbarkeit (K):

Es wurden, wie bei der Prüfung auf Farbschleier beschrieben, Prüfbleche hergestellt. Nach der Entwicklung wurde dann mit einem handelsüblichen Korrekturmittel ein Korrekturfleck so aufgebracht, dap sowohl im entwickelten als auch im nicht-entwickelten Bereich des Bleches eine korrigierte Zone entstand. Die Beurteilung der Korrekturfähigkeit erfolgte durch Zuordnung der visuell ermittelten Bewertungen A, B oder C.
- A =: sehr gut korrigierbar (keine optischen Unterschiede in den korrigierten Bereichen erkennbar)
- B =: korrigierbar (geringe optische Unterschiede in den korrigierten und nicht korrigierten, entwickelten Bereichen erkennbar)
- C =: nicht korrigierbar (starke Farbunterschiede, nicht geeignet für den Offsetdruck)

### Drucktest (D):

Mit den oben beschriebenen Druckformen wurden auf einer Heidelberger GTO-Bogenoffsetmaschine Drucke angefertigt, welche hinsichtlich der im Druck übertragenen Keilstufen, Mikrolinien und Rasterfelder sowie bezüglich der Dauerhaftigkeit der vorgenommenen Korrektur beurteilt wurden.

Mit Blick auf die Eignung als Offsetdruckplatte wurden die Bewertungen A, B oder C vergeben.
A = gut geeignet, hohe Auflagenstabilität (korrigierte Stelle und UGRA-Keil sowie Freilaufverhalten bis über 150.000 Drucke unverändert)
B = geeignet, noch ausreichende Auflagenstabilität (korrigierte Stelle und UGRA-Keil sowie Freilaufverhalten bis ca. 80.000 Drucke unverändert)
C = nicht geeignet, zu geringe Auflagenstabilität (Veränderungen im Druck innerhalb der ersten 70.000 Drucke: Ausbrüche in der Vollfläche, Verlust des Halbstufenkeils, Ausbrüche von Mikrolinien oder Rasterfelder oder Tonen an der Korrekturstelle)

**Tabelle 2:**

| Testergebnisse | | | | | | | | |
|---|---|---|---|---|---|---|---|---|
| lichtempf. Schicht | Nachbehandlung | | | | F | H*** | K | D |
| | Nr. | pH | °C | Gew.-% | | | | |
| L1 oder L2 | B9 | 8 | 50 | 0,5 | B | A | B | A |
| | B10 | 3-7 | 50-90 | 0,2-0,4 | A | A | A | A |
| | B12 | 8 | 50 | 0,3 | B | A | B | A |
| | B13 | 8 | 50 | 0,3-0,5 | A | A | B | A |
| | | | | | | | | |
| L1 oder L2 | V1 | 3 | 50 | - | C | C | B | * |
| | V1 | 6,5 | 50 | - | C | B | C | * |
| | V2 | 5,5 | 80 | 0,1 | C | B | C | * |
| | V3 | >12 | 80 | 1,0 | C | C | C | * |
| | V4 | 1-3 | 50-80 | 0,2-1,5 | C | B | C | * |
| | V5 | 3,5 | 50 | 0,15 | C | B | C | * |
| | V5 | 1,5 | 50 | 1,0 | A | A | A | C |
| | V5 | 1,5 | 50 | 0,5 | A | B | A | B |
| | | | | | | | | |
| L3 | B10 | 9, 5 | 50 | 0,5 | A | B | ** | B |
| | B13 | 8 | 80 | 1,0 | A | A | ** | B |
| | | | | | | | | |
| L3 | V1 | 6,5 | 50 | - | C | C | ** | * |
| | V1 | 8 | 50-80 | - | C | C | ** | * |
| | V2 | 5,5 | 80 | 0,1 | C | C | ** | * |
| | V3 | >12 | 80 | 1,0 | B | B | ** | B |
| | V4 | 1-3 | 50-80 | 0,2-0,5 | C | B | ** | * |
| | V5 | 1-3 | 80 | 1,5 | A | B | ** | C |
| | | | | | | | | |
| L4 | B11 | 7 | 25 | 1,5 | A | B | ** | B |
| | B13 | 6-8 | 50-80 | 2,5 | B | B | ** | B |
| L4 | V1 | 6,5 | 50 | - | C | C | ** | * |
| | V2 | 5,5 | 80 | 0,1 | C | C | ** | * |
| | V3 | >12 | 80 | 1,0 | C | C | ** | * |
| | V4 | 1-3 | 50 | 0,5 | B | B | ** | B |
| | V5 | 3,5 | 50 | 0,5 | B | B | ** | B |

| | | | | | | | | |
|---|---|---|---|---|---|---|---|---|
| *) Da Farbschleier und/oder Hydrophilie mit C bewertet wurden, wurde auf den Drucktest verzichtet. | | | | | | | | |
| **) Wurde nicht geprüft. | | | | | | | | |
| ***) Die Hydrophilie wurde an nachbehandelten Al-Blechen ohne lichtempfindliche Schicht bestimmt. | | | | | | | | |

## Patentansprüche

1. Polyvinylamin-Derivate oder deren Gemische mit Polyethylenimin-Derivaten, dadurch gekennzeichnet, daß die Polyvinylamine die Strukturelemente IIₐ, II_{b} und II_{c} 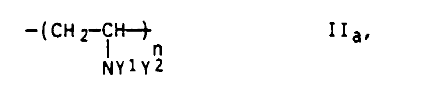 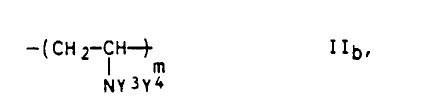 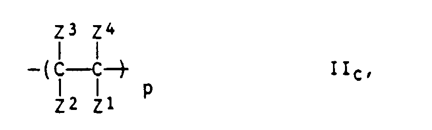 und die Polyethylenimine die Strukturelemente Iₐ und/oder I_{b} 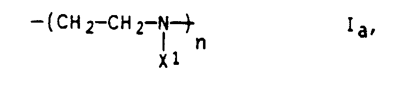 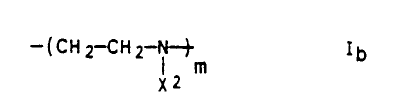 enthalten, wobei für die Polymerisationsgrade n, m und p gilt, daß
n ≥ 1,
m ≥ 0,
p ≥ 0 ist,
und
X¹ CR¹R²PO₃R³R⁴ oder CR¹R²SO₃R³,
X² unabhängig von X¹ ein Wasserstoffatom, CR¹R²PO₃R³R⁴ oder CR¹R²SO₃R³,
Y¹, Y² unabhängig voneinander mindestens eine CHR¹PO₃R³R⁴- oder CHR¹SO₃R³-Gruppierung und eventuell ein Wasserstoffatom,
Y³, Y⁴ unabhängig voneinander und von Y¹ und Y² Wasserstoffatome, CHR¹PO₃R³R⁴- oder CHR¹SO₃R³-Gruppierungen und
Z¹-Z⁴ gleiche oder verschiedene anorganische und/oder organische Reste bedeuten,
worin
R¹, R² unabhängig voneinander ein Wasserstoffatom, eine C₁-C₁₂-Alkylgruppe oder eine Arylgruppe,
R³, R⁴ unabhängig voneinander ein Wasserstoff- oder Alkalimetallatom, oder aber NR⁵R⁶R⁷R⁸ bedeuten, wobei R⁵ bis R⁸ gleiche oder ungleiche Reste sind, die aus der Gruppe Wasserstoff, Alkyl, Aryl, Hydroxyalkyl oder Benzyl gewählt sind.

2. Polyvinylamin-Derivate oder deren Gemische mit Polyethylenimin-Derivaten nach Anspruch 1, dadurch gekennzeichnet, daß m den Wert 0 hat.

3. Polyvinylamin-Derivate nach Anspruch 1 oder 2, dadurch gekennzeichnet, daß p den Wert 0 hat.

4. Polyvinylamin-Derivate oder deren Gemische mit Polyethylenimin-Derivaten nach einem der Ansprüche 1 bis 3, dadurch gekennzeichnet, daß R¹ und R² Wasserstoffatome sowie R³ und R⁴ Wasserstoffatome oder Alkalimetallatome sind.

5. Polyvinylamin-Derivate oder deren Gemische mit Polyethylenimin-Derivaten nach einem der Ansprüche 1 bis 4, dadurch gekennzeichnet, daß das gewichtsmittlere Molekulargewicht der Polyethylenimine zwischen 150 und 2 500 000 und das der Polyvinylamine zwischen 1 000 und 2 500 000 liegt.

6. Polyvinylamin-Derivate oder deren Gemische mit Polyethylenimin-Derivaten nach einem der Ansprüche 1 bis 5, dadurch gekennzeichnet, daß das gewichtsmittlere Molekulargewicht der Polyethylenimine zwischen 5000 und 100 000 und das der Polyvinylamine zwischen 5000 und 500 000 liegt.

7. Platten-, folien- oder bandförmige Trägermaterialien auf der Basis von Aluminium mit einer hydrophilen Schicht, dadurch gekennzeichnet, daß die hydrophile Schicht Polyvinylamin-Derivate oder deren Gemische mit Polyethylenimin-Derivaten gemäß einem der Ansprüche 1 bis 6 enthält.

8. Verwendung der Trägermaterialien nach Anspruch 7 zur Herstellung von lichtempfindlichen Aufzeichnungselementen und von Offsetdruckplatten.

## Claims

1. Polyvinylamine derivatives or mixtures thereof with polyethyleneimine derivatives, characterised in that polyvinylamines contain the structural units IIₐ, II_{b} and II_{c} 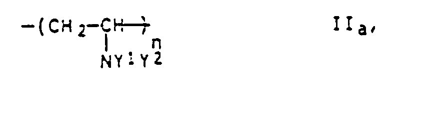 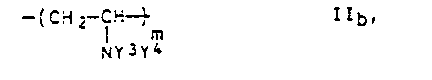 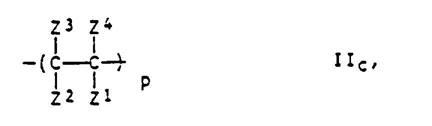 and the polyethyleneimines contain the structural units Iₐ and/or I_{b} 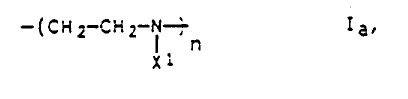 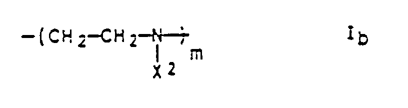 wherein the following values apply for the degrees of polymerisation n, m and p
n ≥ 1,
m ≥ 0,
p ≥ 0,
and
X¹ means CR¹R²PO₃R³R⁴ or CR¹R²SO₃R³,
X² independently of X¹ means a hydrogen atom, CR¹R²PO₃R³R⁴ or CR¹R²SO₃R³,
Y¹, Y² mutually independently mean at least one CHR¹PO₃R³R⁴ or CHR¹SO₃R³ group and possibly a hydrogen atom,
Y³, Y⁴ mutually independently and independently of Y¹ and Y² mean hydrogen atoms, CHR¹PO₃R³R⁴ or CHR¹SO₃R³ groups and
Z¹-Z⁴ mean identical or different inorganic and/or organic residues,
in which
R¹, R² mutually independently mean a hydrogen atom, a C₁-C₁₂ alkyl group or an aryl group,
R³, R⁴ mutually independently mean a hydrogen or alkali metal atom, or alternatively NR⁵R⁶R⁷R⁸, wherein R⁵ to R⁸ are identical or different residues selected from the group comprising hydrogen, alkyl, aryl, hydroxyalkyl or benzyl.

2. Polyvinylamine derivatives or mixtures thereof with poylethyleneimine derivatives according to claim 1, characterised in that m has the value 0.

3. Polyvinylamine derivatives according to claim 1 or 2, characterised in that p has the value 0.

4. Polyvinylamine derivatives or mixtures thereof with poylethyleneimine derivatives according to one of claims 1 to 3, characterised in that R¹ and R² are hydrogen atoms and R³ and R⁴ are hydrogen atoms or alkali metal atoms.

5. Polyvinylamine derivatives or mixtures thereof with poylethyleneimine derivatives according to one of claims 1 to 4, characterised in that the weight average molecular weight of the polyethyleneimines is between 150 and 2500000 and that of the polyvinylamines is between 1000 and 2500000.

6. Polyvinylamine derivatives or mixtures thereof with poylethyleneimine derivatives according to one of claims 1 to 5, characterised in that the weight average molecular weight of the polyethyleneimines is between 5000 and 100000 and that of the polyvinylamines is between 5000 and 500000.

7. Aluminium-based support materials in sheet, foil or web form having a hydrophilic layer, characterised in that the hydrophilic layer contains polyvinylamine derivatives or mixtures thereof with polyethyleneimine derivatives according to one of claims 1 to 6.

8. Use of the support materials according to claim 7 for the production of photosensitive recording members and offset printing plates.

## Revendications

1. Dérivés de polyvinylamines ou leurs mélanges avec des dérivés de polyéthylènimines, caractérisés en ce que les polyvinylamines contiennent les éléments structuraux IIₐ, II_{b} et II_{c} 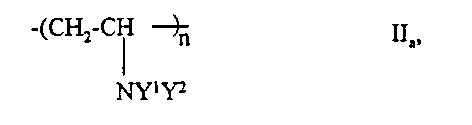 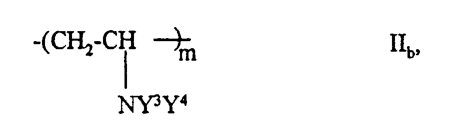 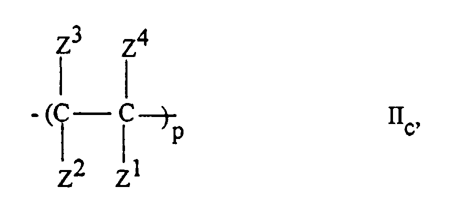 et les polyéthylènimines contiennent les éléments structuraux Iₐ et/ou I_{b} 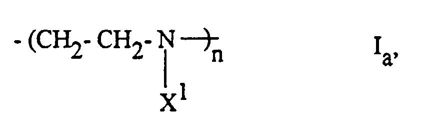 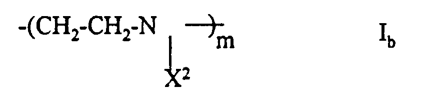 où les degrés de polymérisation n, m et p sont tels que
n ≥ 1,
m ≥ 0,
p ≥ 0,
et
X¹ représente CR¹R²PO₃R³R⁴ ou CR¹R²SO₃R³,
X² représente indépendamment de X¹ un atome d'hydrogène, CR¹R²PO₃R³R⁴ ou CR¹R²SO₃R³,
Y¹, Y² représentent indépendamment l'un de l'autre au moins un groupement CHR¹PO₃R³R⁴ ou CHR¹SO₃R³ et éventuellement un atome d'hydrogène,
Y³,Y⁴ représentent indépendamment l'un de l'autre et de Y¹ et Y² des atomes d'hydrogène, des groupements CHR¹PO₃R³R⁴ ou CHR¹SO₃R³ et
Z¹-Z⁴ représentent des restes inorganiques et/ou organiques identiques ou différents,
où
R¹, R² représentent indépendamment l'un de l'autre un atome d'hydrogène, un groupe alkyle en C₁-C₁₂ ou un groupe aryle,
R³, R⁴ représentent indépendamment l'un de l'autre un atome d'hydrogène ou de métal alcalin, ou bien NR⁵R⁶R⁷R⁸ où R⁵ à R⁸ sont des restes identiques ou différents qui sont choisis dans le groupe constitué par l'hydrogène, alkyle, aryle, hydroxyalkyle ou benzyle.

2. Dérivés de polyvinylamines ou leurs mélanges avec des dérivés de polyéthylènimines selon la revendication 1, caractérisés en ce que m a la valeur 0.

3. Dérivés de polyvinylamines selon la revendication 1 ou 2, caractérisés en ce que p a la valeur 0.

4. Dérivés de polyvinylamines ou leurs mélanges avec des dérivés de polyéthylènimines selon l'une des revendications 1 à 3, caractérisés en ce que R¹ et R² sont des atomes d'hydrogène et R³ et R⁴ sont des atomes d'hydrogène ou des atomes de métaux alcalins.

5. Dérivés de polyvinylamines ou leurs mélanges avec des dérivés de polyéthylènimines selon l'une des revendications 1 à 4, caractérisés en ce que la masse moléculaire moyenne en poids des polyéthylènimines est située entre 150 et 2 500 000 et celle des polyvinylamines est située entre 1 000 et 2 500 000.

6. Dérivés de polyvinylamines ou leurs mélanges avec des dérivés de polyéthylènimines selon l'une des revendications 1 à 5, caractérisés en ce que la masse moléculaire moyenne en poids des polyéthylènimines est située entre 5 000 et 100 000 et celle des polyvinylamines est située entre 5 000 et 500 000.

7. Matériaux supports à base d'aluminium en forme de plaques, feuilles ou bandes comportant une couche hydrophile caractérisés en ce que la couche hydrophile contient des dérivés de polyvinylamines ou leurs mélanges avec des dérivés de polyéthylènimines selon l'une des revendications 1 à 6.

8. Utilisation des matériaux supports selon la revendication 7 pour la fabrication d'éléments d'enregistrement sensibles à la lumière et de plaques d'impression offset.
